# EUROPEAN PATENT APPLICATION

(11) **EP 2 343 768 A2**
(43) Date of publication of application: **13.07.2011**
(21) Application number: 10015849.2
(22) Date of filing: 20.12.2010
(51) Int. Cl.: H01M 10/48, H02J 7/00, G01R 19/165, G01R 31/36, H02H 7/18

(54) **Battery system and method for detecting current restriction state in a battery system**

(30) Priority: 22.12.2009 JP 2009291491
(71) Applicant: Sanyo Electric Co., Ltd., Osaka 570-8677 (JP)
(72) Inventor: Kazunobu, Yokotani, Moriguchi-shi Osaka 570-8677 (JP)
(74) Representative: Hertz, Oliver

(57) **Abstract**

A battery system includes a battery pack 10, a detecting portion 5, a storage portion 6, and a determining portion 7. The battery pack 10 includes parallel battery units 1. The unit 1 includes a current restriction portion 9 and a plurality of battery cells 2. The cells 2 are connected to each other in parallel. The detecting portion 5 detects voltage and current of each unit, and calculates the accumulated current value of each unit. The storage portion 6 stores reference voltage values to be associated the accumulated current value. The determining portion 7 reads one of the reference voltages corresponding to the accumulated value, and compares the read reference voltage with the detection voltage whereby determining that the current restriction portion is brought in a current restriction state if the difference between the detection voltage and the read reference voltage is larger than a predetermined value.

## Description

### BACKGROUND OF THE INVENTION

### 1. Field of the Invention

The present invention relates mainly to a battery system and a method for detecting a current restriction state in a battery system capable of being suitably used as a vehicle power supply device that supplies electric power to an electric motor for driving a vehicle, and in particular to a battery system and a method for detecting a current restriction state in a battery system that includes a number of battery cells that are connected to each other in series and in parallel to increase output current and battery capacity.

### 2. Description of the Related Art

In the case where a battery system includes battery cells that are serially connected to each other, the output voltage of the battery system can be high. Also, in the case where a battery system includes battery cells that are connected in parallel to each other, the total amount of output current and the charged capacity can be high. Accordingly, in the case of battery systems that are required to have high output and high capacity for supplying power to an electric motor for driving a vehicle, a number of battery cells are connected to each other in series and in parallel. This type of battery system is discharged and supplies electric power to the electric motor when the electric motor accelerates or drives the vehicle, and is charged by an electric generator or an external charger if the remaining capacity of the battery system is low. In addition, the battery system is charged by the electric generator in vehicle regenerative braking. For the battery system that includes battery cells that are connected in parallel to each other, and has high capacity capable of providing a large amount of current, it is important to uniformly flow currents in the battery cells connected in parallel to each other so that the battery cells operate in uniform states. The reason is that the unbalance among the battery cells may deteriorate a particular battery cell.

A power supply device has been developed that can equalize currents flowing batteries connected to each other in series (Japanese Patent Laid-Open Publication No. 2006-345660).

In the battery system disclosed in JP-2006-345660-A, series battery units each of which includes a number of battery cells serially connected to each other are connected to each other in parallel.

In the battery system, a constant current circuit is connected to each series battery unit to uniformly flow a current in each series battery. The battery system can uniformly flow currents in the series battery units.

As the number of battery cells employed in a battery system increases, the probability will increase in that a current interruption portion included in each of the battery cells is brought in an interruption state. For example, the battery cell includes a current restriction element such as CID (Current Interrupt Device) and PTC (Positive Temperature Coefficient) element for safety use. This type of current restriction element interrupts current if the internal pressure of the battery cell becomes an abnormal high level, or interrupts or restricts current if over-current flows in the battery cell whereby improving battery safety.

In a battery system that includes a number the battery cells each of which has the current restriction element, since the current restriction element can interrupt or restrict current flowing in a battery cell that is brought in an abnormal state, it is possible to improve the safety of the battery system. For example, in a battery system that includes battery cells serially connected to each other, if the current interruption member in any of battery cells is brought in an interruption state, since current cannot not flow so that the battery system cannot operate, it is easily detect the interruption state of the current interruption member. However, in such a battery system that includes a plurality of battery cells connected to each other in parallel, even if the current interruption member in a particular battery cells is brought in an interruption state, currents can flow through other battery cells connected to this particular battery cell in parallel. Accordingly, since the current amount flowing through the entire battery system or the voltage value of the entire battery system does not drop, the interruption state of the current interruption member cannot be detected.

Not only in the case where current is completely interrupted, for example, but also in the case where the PTC element activates (trips) so that current flowing a particular battery cell is restricted, currents can flow through other battery cells connected to this particular battery cell in parallel. For this reason, such a current restriction state cannot be detected.

Also, irrespective of activation of the current interruption member, if poor battery cell connection or battery cell disconnection occurs, current can flow through other battery cells connected in parallel to a particular battery cell in that current is interrupted or restricted. For this reason, such a poor connection state cannot be detected.

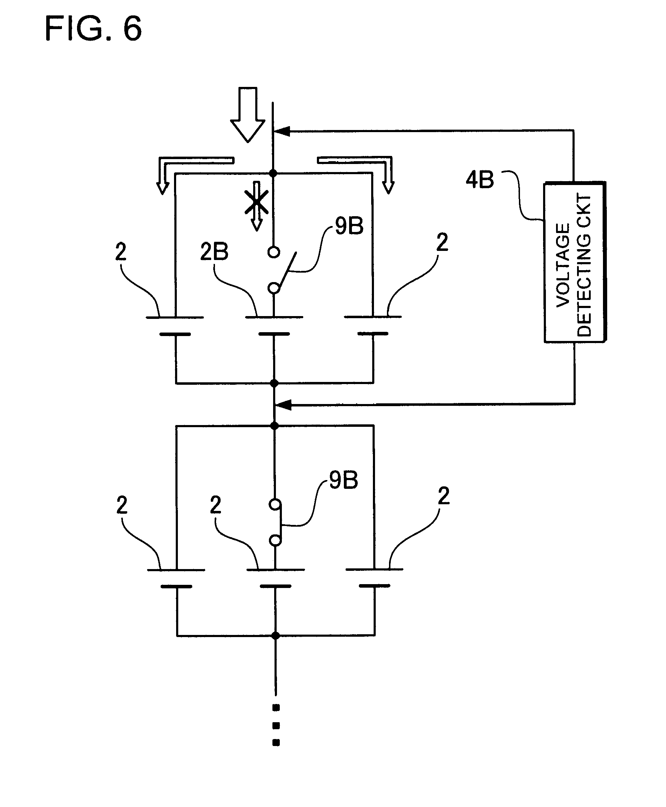

If the flowing current amount of any of the battery cells decreases, the battery system cannot be properly charged/discharged. For example, in a battery pack that includes serially-connected parallel battery units each of which includes three battery cells 2 connected to each other in parallel as shown in Fig. 6, if a current interruption portion 9B of one battery cell 2B is brought in an interruption state so that the one battery cell 2B cannot be properly charged/discharged, only other two battery cells 2 connected to the one battery cell 2B in parallel can be charged/discharged. Since three battery cells are properly connected to each other in parallel in other parallel battery units, the two battery cells 2 will be charged/discharged at a 3/2 times larger amount of current in the parallel battery unit in that the current interruption portion 9B is brought in the interruption state. In a battery system in that the charging/discharging current is limited to the maximum available value, if the particular battery cell 2B cannot be properly charged/discharged, an excess amount of current will flow in other battery cells 2 connected to this battery cell 2B in parallel. In battery systems, the maximum available current of the system is specified based on the amount of current acceptable to each battery cell. For example, in the case of the battery system that includes three battery cells 2 connected to each other in parallel, the maximum available current of the system will be about three times the acceptable current of battery cell 2. However, in the case where the current interruption portion 9B of one of the three battery cells is brought in an interruption state, a larger amount of current will flow in other two battery cells. Since the original maximum available current of the battery system is three times the acceptable current of battery cell in this case, the maximum available current of the battery system in this case is necessarily limited to 2/3 times the original maximum available current.

In the battery system that includes a plurality of battery cells connected to each other in parallel, if such an interruption state of the current interruption portion of the battery cell can be detected, the maximum available current of the battery system in this state can be limited, or the charging/discharging operation can be stopped, which in turn can more safely charges/discharges the battery cells. For example, in a battery system used for a hybrid car, if the interruption state of the current interruption portion of a battery cell is detected, engine starting is only allowed and the vehicle running by the battery system (i.e., charging/discharging operation) is not allowed. Optionally, "Battery Problem", "Drive to Service Garage" or the like can be indicated to users. This allows users to more safely use the battery system.

In the battery system shown in Fig. 6, the voltage detecting portion 4B detects the voltage of the entire one unit that includes the battery cells connected to each other in parallel. However, even if the current interruption portion 9B is brought in the interruption state, since the voltage value almost does not decrease, the interruption state cannot be detected. Also, the battery system disclosed in JP-2006-345660-A cannot detect the interruption state of the current interruption portions of the battery cells that compose the series battery unit, and cannot assure safe charging/discharging operation based on detection of the interruption state of the current interruption portions of the battery cells.

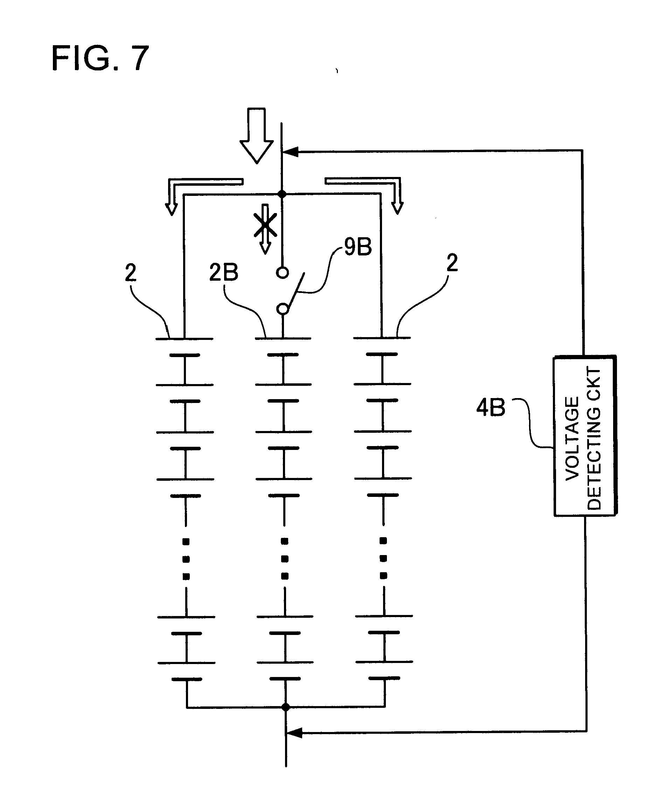

This problem also will arise not only in the construction in that one battery cell is connected on each of the parallel paths connected in parallel to each other as shown in Fig. 6, but also in the construction in that a plurality of battery cells are serially connected to each other on each of a plurality of parallel paths as battery-cell lines connected in parallel to each other. For example, as shown in Fig. 7, in a battery system that includes parallel-connected battery-cell lines each of which includes a number of battery cells serially connected to each other, even when the amount of current decreases that flows in any of the battery-cell lines (the central battery-cell line in Fig. 7), or a current is interrupted in any of the battery-cell lines, these abnormalities cannot be detected based on the voltage or current of the entire battery system.

The present invention is aimed at solving the problem. It is an important object of the present invention is provide a battery system, and a method for detecting a current restriction state in a battery system that includes battery cells that are connected to each other in parallel to increase an output current, and can reliably detect an interruption state of current interruption members of the battery cells, which are connected to each other in parallel, whereby assuring higher safety.

### SUMMARY OF THE INVENTION

To achieve the above object, a battery system according to a first aspect includes a battery pack, a detecting portion, a storage portion, and a determining portion. The battery pack includes at least one parallel battery unit each of which includes a plurality of series battery units. Each of the plurality of series battery units includes a current restriction portion and at least one battery cell serially connected to each other. The plurality of series battery units are connected to each other in parallel. The detecting portion detects voltage and current of each of the at least parallel battery unit, and calculates the accumulated current value of the at least one parallel battery unit. The storage portion stores reference voltage values to be associated the accumulated current value of each of at least one parallel battery unit calculated by the detecting portion. The determining portion reads, from the storage portion, one of the reference voltages corresponding to the accumulated value of each of the at least one parallel battery unit detected by the detecting portion, and compares the read reference voltage with the detection voltage of each of the at least one parallel battery unit detected by the detecting portion whereby determining that the battery cell current restriction portion is brought in a current restriction state if the difference between the detection voltage and the read reference voltage is larger than a predetermined value. According to this battery system, it is possible to detect a current restriction state of the current restriction portion, which cannot be detected by conventional battery systems.

In a battery system according to a second aspect, the detecting portion can detect the accumulated current value of each of the at least one parallel battery unit for a predetermined time period, a period from the start to the end of charging operation, a period from the start to the end of discharging operation, or a period in that the accumulated current value of each of the at least one parallel battery unit reaches a predetermined value so that it can be determined whether the battery cell current restriction portion is brought in a current restriction state.

In a battery system according to a third aspect, the accumulated value of each of the at least one parallel battery unit detected by the detecting portion can be a remaining capacity that is obtained by multiplying of an integrated value of the current by a correction coefficient.

In a battery system according to a fourth aspect, the current restriction portion can be a CID. The determining portion can determine whether the CID is brought in a current interruption state.

In a battery system according to a fifth aspect, the current restriction portion can be a PTC element. The determining portion can determine whether the PTC element is brought in a current restriction state.

In a battery system according to a sixth aspect, the current restriction portion can be poor battery cell connection, or battery cell disconnection. The determining portion can determine whether poor battery cell connection or battery cell occurs.

In a battery system according to a seventh aspect, the battery cells can be lithium-ion rechargeable batteries.

In a battery system according to an eighth aspect, the battery pack can be a power supply that supplies electric power to an electric motor for driving a vehicle.

A battery system according to a ninth aspect includes a battery pack, a detecting portion, and a determining portion. The battery pack includes parallel battery units each of which includes a plurality of series battery units. Each of the plurality of series battery units includes a current restriction portion and at least one battery cell serially connected to each other. The plurality of series battery units are connected to each other in parallel. The detecting portion detects voltages of the parallel battery units. The determining portion compares a voltage of one of the parallel battery units detected by the detecting portion with voltages of other of the parallel battery units to detect the voltage difference, and determines that the battery cell current restriction portion is brought in a current restriction state if the voltage difference is larger than a predetermined value.

A battery cell current restriction state detection method according to an eleventh aspect for detecting a battery cell current restriction state in a battery system includes a detection step, a calculation step, a reading step, a comparison step, and a determination step. The battery pack includes at least one parallel battery unit each of which includes a plurality of series battery units. Each of the plurality of series battery units includes a current restriction portion and at least one battery cell serially connected to each other. The plurality of series battery units are connected to each other in parallel. In the detection step, the voltage and current of each of at least one parallel battery unit is detected by a detecting portion. In the calculation step, the accumulated current value of each of at least one parallel battery unit is calculated. In the reading step, from a storage portion that stores reference voltages, one of the reference voltages corresponding to the accumulated value of each of at least one parallel battery unit is read. In the comparison step, the read reference voltage is compared with the detection voltage of each of at least one parallel battery unit detected by the detecting portion. In the determination step, it is determined that the battery cell current restriction portion is brought in a current restriction state if the difference between the detection voltage and the read reference voltage is larger than a predetermined value.

The thus-constructed battery system can increase an output current and a battery capacity by employing battery cells that are serially connected to each other, and can reliably detect a current restriction state on serially connected battery cells, whereby assuring higher safety. The operation of this battery system that can detect a current restriction state on battery cells is described with reference to Fig. 6. In this Figure, it is assumed that the current restriction portion 9B in the center battery cell is brought in a current restriction state (in this example, a CID is in activation for interrupting current). In the battery cell current restriction state, although charging current flows only into battery cells on the both sides in parallel connection so that the current amount of each of the battery cells on the both sides will increase, the voltage rise ratio due to the increased charging current is small. For this reason, it is difficult to detect the current restriction state. This difficulty will increase as the number of parallel connection lines increases.

For example, in the case where current is interrupted by the CID as current restriction portion 9B so that the center battery cell cannot be charged, or in the case where the PTC is tripped so that the resistance of the center battery cell is increased, charging current will flow into only other battery cells on the both sides so that only the battery cells on the both sides will be charged. In this case, charging current will increase that flows into the battery cells on the both sides. Since the battery cells on the both sides are charged at larger charging current, their charged capacity will be larger. For this reason, the voltage rise of a parallel battery unit in a battery cell current restriction state is likely to be higher relative to the charged capacity of the parallel battery unit.

On the other hand, under battery pack discharging operation, in a parallel battery unit that includes the center battery cell the remaining capacity of which is prevented from being discharged by the current restriction state, since the discharged capacity from the battery cells on the both sides is larger, the voltage reduction of this parallel battery unit will be larger relative to the discharged capacity of this parallel battery unit. As discussed above, in a parallel battery unit in the battery cell current restriction state, under charging operation and discharging operation, the variation ratio of its voltage relative to its charged capacity is different from a normal parallel battery unit. However, the battery cell in the current interruption state cannot be charged. Accordingly, its charged capacity will be substantially zero.

The aforementioned battery system stores the variation of voltage as reference voltages relative to charged/discharged capacity of a normal parallel battery. In battery pack charging/discharging operation, a charged or discharged capacity, and a voltage of a parallel battery unit are detected. In a parallel battery unit in that all battery cells are not in the current restriction state, its detected voltage agrees with the reference voltage. However, in a parallel battery unit in that any of the battery cell is brought in a current restriction state, since its actual charged/discharged capacity is deviated due to the current restriction state, its detected voltage or the variation amount of its voltage will be different from the reference voltage or the variation amount of reference voltage. For this reason, after the charged/discharged capacity and voltage of a parallel battery unit are detected, the reference voltage corresponding to the detected charged/discharged capacity is compared with the detected voltage corresponding to the detected charged/discharged capacity, alternatively, the variation amount of detected voltage corresponding to the detected charged/discharged capacities is compared with the variation amount of reference voltages corresponding to the detected charged/discharged capacities. As a result, it is possible to detect a current restriction state. In particular, in the case where battery system not only compares the reference voltage with the detected voltage, but also compares the variation amount of detected voltage with variation amount of reference voltages corresponding to the detected charged/discharged capacities, it is possible to more reliably detect a current restriction state, and to more safely charge/discharge the battery pack.

The above and further objects of the present invention as well as the features thereof will become more apparent from the following detailed description to be made in conjunction with the accompanying drawings.

### BRIEF DESCRIPTION OF THE DRAWINGS

Fig. 1 is a block diagram showing a power supply device according to one embodiment of the present invention;
Fig. 2 is a flowchart showing the procedure of detecting a current restriction state;
Fig. 3 is a block diagram showing an exemplary hybrid car that is driven by an engine and an electric motor, and includes the power supply device;
Fig. 4 is a block diagram showing an exemplary electric vehicle that is driven only by an electric motor, and includes the power supply device;
Fig. 5 is a block diagram showing a power supply device according to a modified embodiment;
Fig. 6 is a schematic diagram showing parallel battery units, with one of battery cells connected to each other in parallel in one of the parallel battery units being brought in a current restriction state; and
Fig. 7 is a schematic view showing a battery system that includes parallel-connected series battery units each of which includes a plurality of serially connected battery cells, with one of series battery units being brought in a current restriction state.

### DETAILED DESCRIPTION OF THE EMBODIMENT(S)

The following description will describe embodiments according to the present invention with reference to the drawings.

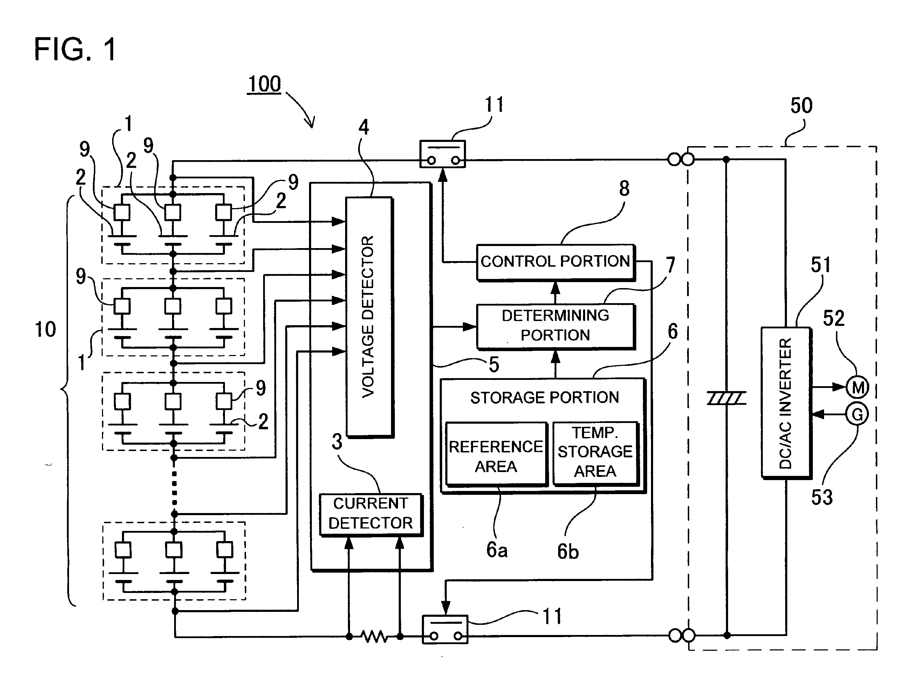

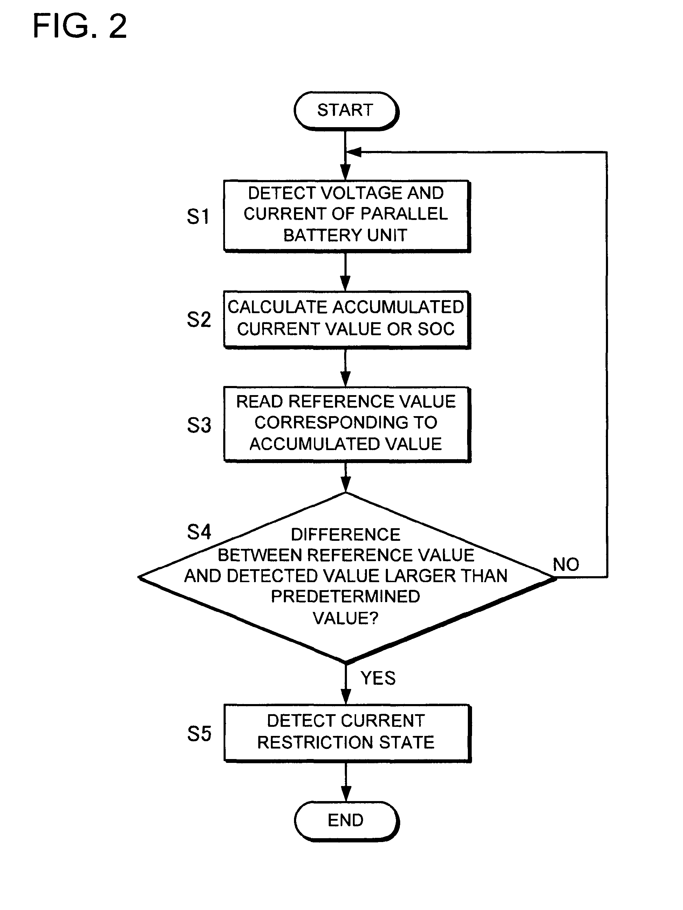

The following description will describe a battery system according to the embodiment of the present invention with reference to Figs. 1 to 2. In this embodiment, the present invention is applied to a vehicle power supply device. Fig. 1 shows a block diagram of the power supply device. Fig. 2 shows a flowchart of the procedure for detecting a current restriction state. A power supply device 100 shown in these Figures is suitable mainly for power supplies of electric vehicles such as hybrid cars that are driven by both an engine and an electric motor, and electric vehicles that are driven only by an electric motor. However, the power supply device according to the present invention can be used for vehicles other than hybrid cars or electric vehicles, and can be also used for applications other than electric vehicle that require high power.

The vehicle power supply device 100 shown in Fig. 1 is installed in a vehicle such as hybrid car, fuel-cell vehicle and electric vehicle, and is connected to an electric motor 52 in a vehicle load 50. The electric motor 52 is powered by the vehicle power supply device 100, and drives the vehicle. As shown in Fig. 1, the vehicle load 50 includes a DC/AC inverter 51, the electric motor 52 and an electric generator 53. The DC/AC inverter 51 is connected on the input side. The electric motor 52 and the electric generator 53 are connected on the output side. The DC/AC inverter 51 converts direct current from a vehicle-driving battery 1 into three-phase alternating current, and controls power supplied to the electric motor 52. In addition, the DC/AC inverter 51 converts output from the electric generator 53 into direct current so that the vehicle-driving battery 1 of the power supply device 100 is charged.

A vehicle load can be used that includes a buck-boost converter connected on the input side of the DC/AC inverter. This buck-boost converter boosts the output voltage of the power supply device, and provides the boosted voltage to the electric motor. In this vehicle load, the output voltage of the power supply device is boosted by buck-boost converter, and is provided to the electric motor via the DC/AC inverter, while the output from the electric generator is converted into direct current by the DC/AC inverter, and is reduced in voltage by the buck-boost converter to charge the battery.

The vehicle power supply device 100 shown in Fig. 1 includes a battery pack 10, a current detecting circuit 3, a voltage detecting circuit 4, a determining portion 7, a reference area 6a, contactors 11, and a control portion 8. The battery pack 10 supplies electric power to the electric motor 52 of the vehicle load 50. The current detecting portion 3 detects a current of the battery pack 10. The voltage detection portion 4 detects voltages of the battery cells 2. The determining portion 7 determines, based on the detection voltages detected by cell voltage detecting circuit 4 and the detection current detected by the current detecting circuit 3, whether a battery cell 2 is brought in a current restriction state. The reference area 6a stores reference information. The control portion 8 opens/closes the contactors 11.

The current detecting circuit 3 and the voltage detecting circuit 4 composes a detecting portion 5 that detects voltage and current of each of parallel battery units 1, and calculates the accumulated current value of each of the at parallel battery units 1. The determining portion 7 reads, from the reference area 6a, one of the reference voltages corresponding to the accumulated value of each of the parallel battery units 1 detected by the detecting portion 5, and compares the read reference voltage with the detection voltage of the each of the parallel battery units 1 detected by the detecting portion 7 whereby determining that a battery cell 2 is brought in a current restriction state if the difference between the detection voltage and the read reference voltage is larger than a predetermined value.

### (Storage Portion 6)

A storage portion 6 includes the reference area 6a, and a temporary storage area 6b. The reference area 6a stores reference voltage values to be associated the accumulated current value of each of the at least one parallel battery unit 1 calculated by the detecting portion 5. A non-volatile memory such as ROM and E²PROM can be used as the reference area 6a. The temporary storage area 6b temporarily stores data. A volatile memory such as RAM can be used as the temporary storage area 6b. Although the storage portion 6 is constructed separately from the determining portion 7 in the case of Fig. 1, needless to say, the storage portion 6 can be constructed as the same member as the determining portion 7. For example, a chip, IC, or the like with a semiconductor memory element mounted in a single package can be used.

The reference area 6a of the storage portion 6 stores reference data of the relationship between voltage value variation and current integrated value variation that has been previously obtained based on measured experimental results. The reference data can be stored in a form of table or calculation formula.

### (Detecting Portion 5)

The detecting portion 5 detects the voltage and current of each of the parallel battery units 1. In addition, the detecting portion 5 also calculates the voltage value variation and the current integrated value (or SOC) variation. The accumulated value of the current of each of the parallel battery units 1 detected by the detecting portion 5 is a remaining capacity that is obtained by multiplying of an integrated value of the current by a correction coefficient.

The detecting portion 5 detects the accumulated current value of the each of the parallel battery units 1 for a predetermined time period, a period from the start to the end of charging operation, a period from the start to the end of discharging operation, or a period in that the accumulated current value of the each of the parallel battery units 1 reaches a predetermined value so that it is determined whether a battery cell 2 is brought in a current restriction state.

In this embodiment, although the detecting portion calculates the voltage value variation and the current integrated value variation, the determining portion may calculate the voltage value variation and the current integrated value variation. The detecting portion and the determining portion can be constructed as separated members. Alternatively, they may be integrally constructed. Also, any members can be integrally constructed. For example, the determining portion and the control portion can be integrally constructed. Also, any member can be constructed of separated members.

### (Determining Portion 7)

The determining portion 7 determines whether a battery cell 2 is brought in a current restriction state or not based on the actually-detected values detected by the detecting portion 5, and the reference data stored in the storage portion 6. In addition, the determining portion 7 can compare a voltage of one of the parallel battery units detected by the detecting portion 5 is compared with a voltage of other of the parallel battery units to detect the voltage difference, and can determine that a battery cell 2 is brought in a current restriction state in the one of the parallel battery units if the voltage difference is larger than a predetermined value. In addition, the determination result can be provided to the control portion 8. Based on the determining result, the control portion 8 can take proper actions, for example, can inform the vehicle side that charging/discharging current is required to be limited.

### (Battery Pack 10)

The battery pack 10 powers the electric motor 52 for driving the vehicle via the DC/AC inverter 51. In order to supply a large amount of electric power to the electric motor 52, the battery pack 10 includes a plurality of parallel battery units 1 each of which includes a plurality of battery cells 2 that are connected to each other in parallel. The parallel battery units 1 are serially connected to each other whereby providing high output voltage. Nickel-hydrogen batteries or lithium-ion rechargeable batteries can be used as the battery cells 2. However, any rechargeable batteries including nickel-cadmium rechargeable batteries may be as the battery. To supply a large amount of electric power to the electric motor 52, the output voltage of the battery pack 10 can be set at a value of 100 to 400 V, for example.

### (Current Restriction Portion 9)

Current restriction portions 9 are serially connected to the battery cells 2. Each of the current restriction portions 9 is connected to corresponding one of the battery cells 2, which are connected in parallel to each other in each of the parallel battery units 1. A CID or a PTC element can be used as the current restriction portion 9. In particular, a CID is preferably used as the current restriction portion 9. The CID means a current interruption device. If a battery cell 2 is brought into an abnormal state such as over-current discharged state or over-current charged state, the CID is operated by the abnormal battery voltage, and interrupts current. Although the CID is illustrated outside the battery cell 2 in Fig. 1 for ease of illustration, typically, the CID is included inside the battery cell 2. However, the current interception portion such as CID may be constructed separately from the battery cell as external device.

The PTC element has a variable resistance that can be increased by heat generated by the battery cell, and limits a flowing current amount. The CID is typically used as a protection element for urgent abnormalities. Once the CID activates and interrupts current, the battery cell cannot be used again. Contrary to this, when the temperature decreases, the resistance of the PTC element also decreases so that the normal operation of the battery cell can recover. Optionally, the CID and the PTC element can be used together. In this case, the activation temperatures of the CID and the PTC element can be set at different temperatures. If the temperature of the battery cell rises to a relatively lower abnormal level, the battery cell is protected by the PTC element. If the temperature of the battery cell rises to a relatively lower abnormal level, the battery cell is protected by the CID.

The current restriction portion is not limited to such a member that intendedly limits or interrupts current, but can also be unintended poor contact or disconnection. For example, if electric poor contact or disconnection occurs, the amount of current flowing a particular battery cell drops or current flowing a particular battery cell is interrupted. Accordingly, a similar problem will arise, that is, parallel connection of a plurality of battery cells prevents that such conditions can be detected. Also, in this case, since such a current restriction state can be detected by the later-discussed determining portion, the battery system can determine that current is restricted by disconnection, poor contact or the like. Therefore, it is possible to take proper actions, for example, to properly reduce charging/discharging current.

### (Contactor 11)

The contactors 11 are connected on the positive and negative output sides of the battery pack 10 in the power supply device 100 shown Fig. 1. The contactors 11 are ON, when the vehicle is in operation, in other words, when the ignition switch of the vehicle is turned ON. The contactors 11 are OFF, when the vehicle is not in operation. Although the contactors 11 are connected on the positive and negative output sides of the battery pack 10 in the power supply device 100 shown in Fig. 1, only one contactor may be connected on the positive or negative output side.

### (Current Restriction State Detection Method)

According to the aforementioned construction, the battery system can detect a current restriction state in the battery system that includes the battery pack having the battery cells 2 connected to each other in parallel. The following description will describe the procedure of detecting the current restriction state with reference to a flowchart of Fig. 2.

At Step S1, voltage and current values of the parallel battery units 1 are actually detected by the detecting portion 5. In this embodiment, the voltage detecting circuit 4 of the detecting portion 5 detects voltage values of the parallel battery units 1 each of which includes the battery cell 2 connected to each other in parallel. The current detecting circuit 3 detects a current value flowing in the parallel battery units 1. The voltage and current values are detected periodically at a predetermined interval or at predetermined timing. For example, the voltage and current values can be detected periodically at a predetermined interval within a range of 0.5 to 5 seconds.

Subsequently, at Step S2, current values can be accumulated to calculate the battery remaining capacity (SOC: State of Charge) if necessary. This SOC calculation is executed by the detecting portion 5. The obtained voltage value and current integrated value are stored as actually-detected remaining capacities of the parallel battery units 1 as time-series data in the temporary storage area 6b of the storage portion 6. Accumulated values may be used in stead of SOC in calculation and determination. This step can be skipped in the case where accumulated current values are not required.

Subsequently, at Step S3, the parallel battery unit 1 reference voltage corresponding to the accumulated value is read from the storage portion 6. In this embodiment, the corresponding value is read from the reference data that is previously stored in the reference area 6a of the storage portion 6, and represents the relationship between voltage value variation and current accumulated value variation.

After that, in Step S4, the determining portion 7 compares the read reference value with the actually-detected value of the parallel battery unit 1. In this embodiment, the determining portion 7 reads the reference value corresponding to the current accumulated value variation obtained based on the actually-detected value, which will be voltage variation in the normal condition, from the storage portion 6, and then compares the read reference value with the voltage variation obtained based on the actually-detected values. After that, it is determined whether the difference between the read reference value and the voltage variation obtained based on the actually-detected values exceeds a predetermined threshold value. If this difference is larger than the predetermined value, the procedure goes to Step S5 in that it is determined that a battery cell 2 is brought in the current restriction state by activation of current restriction portion 9 or the like, and in that the control portion 8 or the like can take required actions. If that difference is smaller than the predetermined value, it is not determined that battery cell 2 is brought in the current restriction state, and the procedure returns to Step S1. Thus, the foregoing steps are repeated. Although, conventionally, it has been difficult to detect a current restriction state in battery cells that are connected to each other in parallel, this power supply device can effectively detect a current restriction state in battery cells that are connected to each other in parallel.

Although the determining portion has been described that uses the current accumulated value, the determining portion can compare a voltage of one of the parallel battery units with voltages of other of the parallel battery units to detect the voltage difference, and can determine that a battery cell is brought in a current restriction state in the one of the parallel battery units if the voltage difference is larger than a predetermined value.

Conventionally, in a battery system that includes a plurality of battery cells connected to each other in parallel, if one or more battery cell among the battery cell is brought in a current restriction state, since current flows only into other battery cells, it is difficult to detect the current restriction state only based on the voltage value variation. In the aforementioned power supply device, the variation of the capacity or voltage of the parallel battery unit is monitored. Also, the variation of the capacity or voltage expected in the normal condition is previously recorded. Accordingly, abnormalities can be determined by comparing the monitored variation and the expected variation. In other words, based on calculation charging/discharging currents flowing in the battery cells of the parallel battery unit, deviation is monitored between the expected capacity or voltage variation and the calculated capacity or voltage variation whereby detecting abnormalities when the monitored deviation exceeds a predetermined threshold value. Therefore, a safe battery system can be constructed.

The vehicle power supply device can be installed on electric vehicles such as hybrid cars that are driven by both an engine and an electric motor, and electric vehicles that are driven only by a electric motor. The power supply device can be used as a power supply device for these types of vehicles.

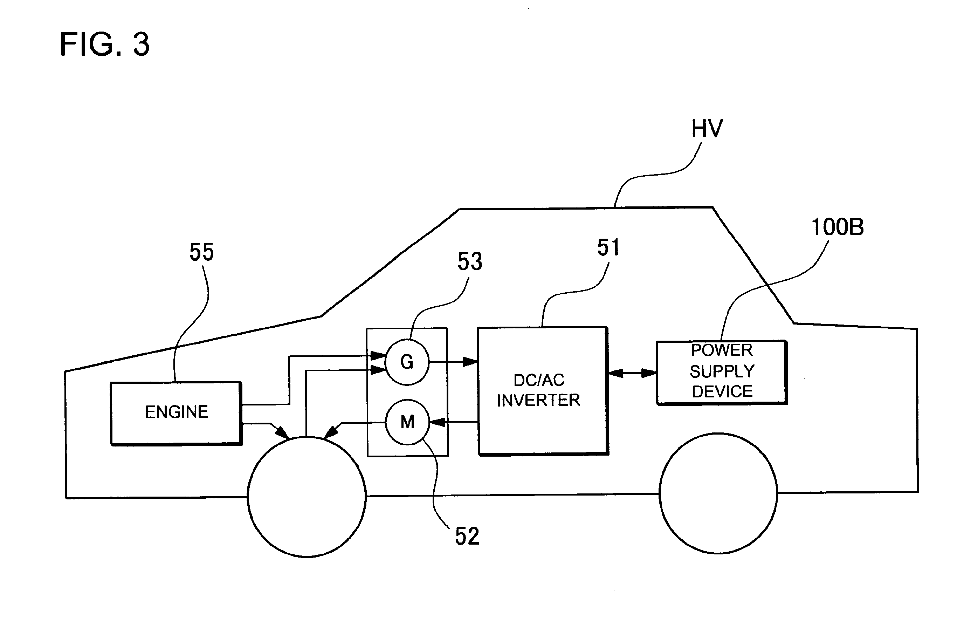

Fig. 3 is a block diagram showing an exemplary hybrid car that is driven both by an engine 55 and an electric motor 52, and includes the vehicle power supply device 100. The illustrated vehicle HV includes the electric motor 52 and the engine 55 that drive the vehicle HV, the vehicle power supply device 100B that supplies electric power to the electric motor 52, and an electric generator 53 that charges batteries of the vehicle power supply device 100B. The vehicle power supply device 100B is connected to the electric motor 52 and the electric generator 53 via a DC/AC inverter 51. The vehicle HV is driven both by the electric motor 52 and the engine 55 with the batteries of the vehicle power supply device 100B being charged/discharged. The electric motor 52 is energized and drives the vehicle in a poor engine efficiency range, e.g., in acceleration or in a low speed range. The electric motor 52 is energized by electric power is supplied from the vehicle power supply device 100B. The electric generator 53 is driven by the engine 55 or by regenerative braking when users brake the vehicle so that the batteries of the vehicle power supply device 100B are charged.

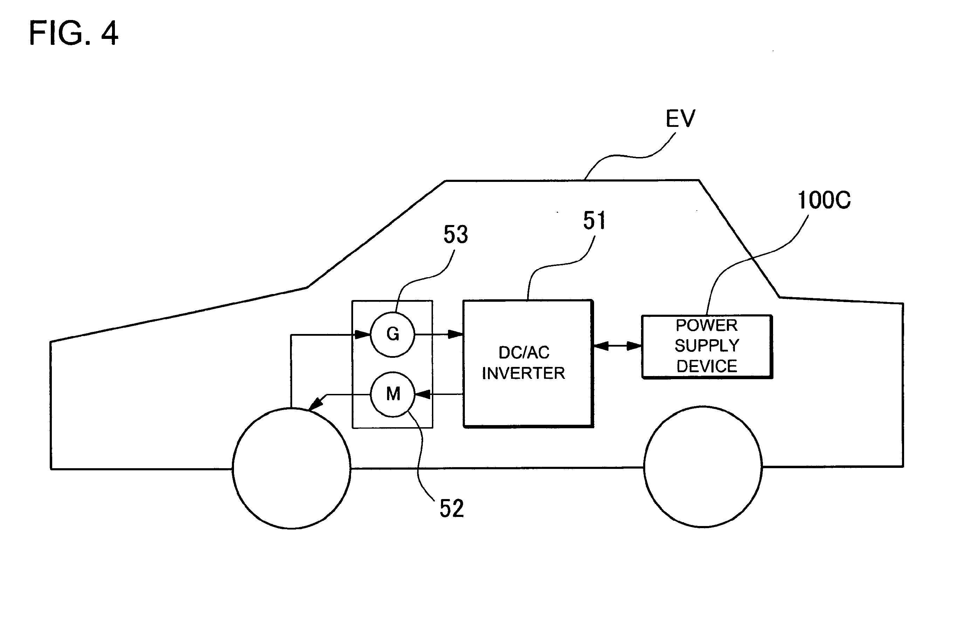

Fig. 4 shows an exemplary electric vehicle that is driven only by an electric motor 52, and includes the vehicle power supply device 100C. The illustrated vehicle EV includes an electric motor 52 that drives the vehicle EV, the vehicle power supply device 100C that supplies electric power to the electric motor 52, and an electric generator 53 that charges batteries of the vehicle power supply device 100C. The electric motor 52 is energized by electric power is supplied from the vehicle power supply device 100C. The electric generator 53 can be driven by vehicle EV regenerative braking so that the batteries of the vehicle power supply device 100C are charged.

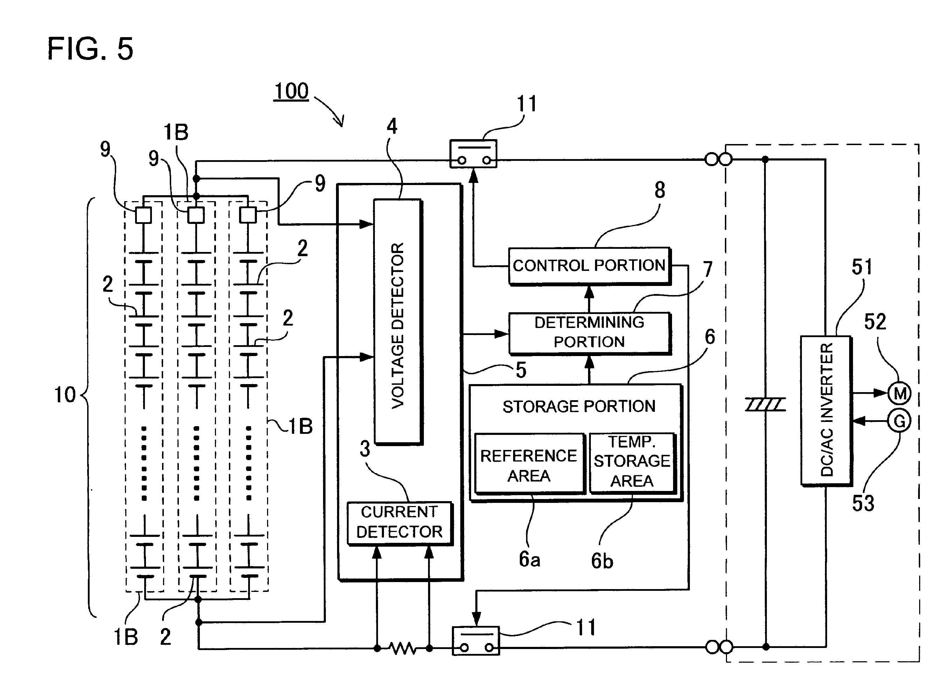

It has been described that each of the parallel battery units 1 includes the battery cells 2 each of which is serially connected to corresponding one of the current restriction portions 9, and the battery cells 2 are connected to each other in parallel in each of the parallel battery units 1 in the embodiment shown in Fig. 1. However, the present invention is not limited to this construction. The present invention can be applied to the construction shown in Fig. 5 in that series battery units 1 B each of which includes a plurality of serially-connected battery cells 2 are connected to each other in parallel. In this construction, only one current restriction portion 9 is required for each of the series battery units 1 B.

As discussed above, in the battery system that includes one or more battery cells connected to each other in parallel, if one or more current restriction portions activate (a CID or the like activates, or poor contact occurs), the apparent charged/discharged capacity of a corresponding battery unit decreases. Based on this apparent charged/discharged capacity decrease, by monitoring the variation of voltage of the parallel battery unit in charging/discharging operation, it can be determined whether disconnection occurs or whether the CID opens. For example, in the case where four battery cells are connected to each other in parallel, if one of the battery cells is disconnected, or if the CID corresponding to one of the battery cells opens, the charged/discharged capacity of the battery unit in this current restriction state will be 3/4 time the normal charged/discharged capacity. Since the current amount per cell in this state will be 4/3 times the normal current amount, the variation of voltage will increase. As a result, it is possible to detect the current restriction state. According to this method, it is possible to detect abnormalities such as disconnection of any of the parallel-connected battery cells and activation of the CID corresponding to any of the parallel-connected battery cells. Accordingly, types of control operation can be properly selected. Therefore, the battery system can safely be used.

### Industrial Applicability

A battery system, and a method for detecting a current restriction state in a battery system according to the present invention can be suitably applied to power supple devices of plug-in hybrid vehicles and hybrid electric vehicles that can switch between the EV drive mode and the HEV drive mode, electric vehicles, and the like.

## Claims

1. A battery system comprising:
a battery pack (10) that includes at least one parallel battery unit (1) each of which includes a plurality of series battery units each of which includes a current restriction portion (9) and at least one battery cell (2) serially connected to each other, the plurality of series battery units being connected to each other in parallel;
a detecting portion (5) that detects voltage and current of each of the at least one parallel battery unit (1), and calculates the accumulated current value of each of the at least parallel battery unit (1); and
a storage portion (6) that stores reference voltage values to be associated the accumulated current value of each of the at least one parallel battery unit (1) calculated by said detecting portion (5),
**characterized in that**:
the battery system further comprises a determining portion (7) that reads, from said storage portion (6), one of the reference voltages corresponding to the accumulated value of each of the at least one parallel battery unit (1) detected by said detecting portion (5), and compares the read reference voltage with the detection voltage of said each of the at least one parallel battery unit (1) detected by said detecting portion (5) whereby determining that the battery cell (2) current restriction portion (9) is brought in a current restriction state if the difference between the detection voltage and the read reference voltage is larger than a predetermined value.

2. The battery system according to claim 1, wherein said detecting portion (5) detects the accumulated current value of each of the at least one parallel battery unit (1) for a predetermined time period, a period from the start to the end of charging operation, a period from the start to the end of discharging operation, or a period in that the accumulated current value of each of the at least one parallel battery unit (1) reaches a predetermined value so that it is determined determines whether the battery cell (2) current restriction portion (9) is brought in a current restriction state.

3. The battery system according to claim 1 or 2, wherein the accumulated value of the current of each of the at least one parallel battery unit (1) detected by said detecting portion (5) is a remaining capacity that is obtained by multiplying of an integrated value of the current by a correction coefficient.

4. The battery system according to any of claims 1 to 3, wherein said current restriction portion (9) is a CID, wherein the determining portion (7) determines whether the CID is brought in a current interruption state.

5. The battery system according to any of claims 1 to 3, wherein said current restriction portion (9) is a PTC element, wherein the determining portion (7) determines whether the PTC element is brought in a current restriction state.

6. The battery system according to any of claims 1 to 3, wherein said current restriction portion (9) is poor battery cell (2) connection, or battery cell (2) disconnection, wherein the determining portion (7) determines whether poor battery cell (2) connection or battery cell (2) occurs.

7. The battery system according to any of claims 1 to 6, wherein said at least one battery cell (2) is lithium-ion rechargeable batteries.

8. The battery system according to any of claims 1 to 7, wherein said battery pack (10) is a power supply that supplies electric power to an electric motor for driving a vehicle.

9. A battery cell current restriction state detection method for detecting a battery cell current restriction state in a battery system that includes a battery pack (10) having at least one parallel battery unit (1) each of which includes a plurality of series battery units each of which includes a current restriction portion (9) and at least one battery cell (2) serially connected to each other, the plurality of series battery units being connected to each other in parallel, wherein the method comprising the steps of:
detecting voltage and current of each of the at least one parallel battery unit (1) by a detecting portion (5);
calculating the accumulated current value of each of at least one the parallel battery unit (1);
reading, from a storage portion (6) that stores reference voltages, one of the reference voltages corresponding to the accumulated value of each of the at least one parallel battery unit (1);
comparing the read reference voltage with the detection voltage of said each of the at least one parallel battery unit (1) detected by said detecting portion (5); and
determining that the battery cell (2) current restriction portion (9) is brought in a current restriction state if the difference between the detection voltage and the read reference voltage is larger than a predetermined value.
